(19) Europäisches Patentamt / European Patent Office / Office européen des brevets

(11) **EP 4 220 299 A1**

(12) **EUROPEAN PATENT APPLICATION**
published in accordance with Art. 153(4) EPC

(43) Date of publication:
**02.08.2023 Bulletin 2023/31**

(21) Application number: **21872620.6**

(22) Date of filing: **27.09.2021**

(51) International Patent Classification (IPC):
**G03F 1/24** (2012.01)          **G03F 1/54** (2012.01)
**C23C 14/08** (2006.01)

(52) Cooperative Patent Classification (CPC):
**C23C 14/08; G03F 1/24; G03F 1/54**

(86) International application number:
**PCT/JP2021/035429**

(87) International publication number:
**WO 2022/065494 (31.03.2022 Gazette 2022/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.09.2020 JP 2020162226**

(71) Applicant: **Toppan Photomask Co., Ltd.
Tokyo 108-0023 (JP)**

(72) Inventors:
• **MATSUI Kazuaki
Tokyo 110-0016 (JP)**
• **GODA Ayumi
Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57)     There are provided a reflective photomask blank and a reflective photomask which improve the dimensional accuracy and the shape accuracy of a pattern to be transferred onto a wafer and enable the long use. A reflective photomask blank (10) according to this embodiment includes: a substrate (1); a reflective layer (2); and an absorption layer (4) in this order, in which the absorption layer (4) is a layer containing a material of a first material group and containing a material of a second material group, the content of the material of the first material group decreases from the side of the substrate (1) toward the side of an outermost surface (4a) of the absorption layer (4), and the content of the material of the second material group increases from the side of the substrate (1) toward the side of the outermost surface (4a) of the absorption layer (4). The first material group contains Te, Co, Ni, Pt, Ag, Sn, In, Cu, Zn, and Bi, and oxides, nitrides, and oxynitrides thereof. The second material group contains Ta, Cr, Al, Si, Ru, Mo, Zr, Ti, Zn, In, V, Hf, and Nb, and oxides, nitrides, and oxynitrides thereof.

FIG. 1

EP 4 220 299 A1

**Description**

Technical Field

The present invention relates to a reflective photomask used in lithography using a light in the ultraviolet region as a light source and a reflective photomask blank used for producing the same.

Background Art

In a manufacturing process for semiconductor devices, a demand for miniaturization by a photolithography technology has increased with the miniaturization of the semiconductor devices. The minimum resolution dimension of a transfer pattern in the photolithography largely depends on the wavelength of an exposure light source, and the minimum resolution dimension can be made smaller as the wavelength is shorter. Therefore, as the exposure light source, a conventional ArF excimer laser light having a wavelength of 193 nm has been replaced with a light in the EUV (Extreme Ultra Violet) region having a wavelength of 13.5 nm.

The light in the EUV region is absorbed by most materials at a high ratio, and therefore a reflective photomask is used as a photomask for EUV exposure (EUV mask) (see PTL 1, for example). PTL 1 discloses an EUV photomask obtained by forming a reflective layer containing a multi-layer film in which molybdenum (Mo) layers and silicon (Si) layers are alternately deposited on a glass substrate, forming a light absorption layer containing tantalum (Ta) as the main ingredient on the reflective layer, and forming a pattern on the light absorption layer.

Further, in the EUV lithography, a dioptric system utilizing light transmission cannot be used as described above, and therefore an optical system member of an exposure machine is not a lens but a reflective type (mirror).

This poses a problem that an incident light and a reflected light on a reflective photomask (EUV mask) cannot be coaxially designed. Thus, in the EUV lithography, a technique is commonly employed which includes making the EUV light incident by tilting the optical axis by 6° from the vertical direction of the EUV mask and guiding a reflected light reflected at an angle of -6° to a semiconductor substrate.

As described above, the optical axis is tilted through the mirror in the EUV lithography, which has sometimes posed a problem referred to as a so-called "shadowing effect" in which the EUV light incident on the EUV mask creates a shadow of a mask pattern (patterned light absorption layer) of the EUV mask.

In a current EUV mask blank, a film containing tantalum (Ta) as the main ingredient having a film thickness of 60 to 90 nm is used as the light absorption layer. When the exposure of the pattern transfer is performed with an EUV mask produced using the mask blank, there is a risk of causing a reduction in the contrast at an edge part to be shadowed by the mask pattern, depending on the relationship between the incident direction of the EUV light and the orientation of the mask pattern. Consequently, problems, such as an increase in line edge roughness of the transfer pattern on the semiconductor substrate and an inability to form a line width with a target dimension, occur, thereby deteriorating the transfer performance in some cases.

Thus, a reflective mask blank in which a material forming the absorption layer is changed from tantalum (Ta) to a material having high absorptivity (extinction coefficient) to the EUV light and a reflective mask blank in which a material having high absorptivity to the EUV light is added to tantalum (Ta) have been studied. For example, PTL 2 describes a reflective mask blank in which the absorption layer is formed of a material containing Ta as the main ingredient in a proportion of 50 at% or more and further containing at least one element selected from Te, Sb, Pt, I, Bi, Ir, Os, W, Re, Sn, In, Po, Fe, Au, Hg, Ga, and Al.

The wall angle on the cross-section side after patterning the absorption layer preferably has a rectangular shape having a nearly vertical angle . In the case of a stepped shape or a tapered shape, there is a concern that unintended attenuation/amplification of an exposure light or a change in the reflected light intensity in a pattern end portion deteriorates the transfer performance.

Further, the mirror is known to be contaminated with by-products (e.g., Sn) or carbon caused by the EUV. The accumulation of contaminants on the mirror reduces the reflectance of the surface and reduces the throughput of a lithographic apparatus. To address this problem, PTL 3 discloses a method for removing the contaminants from the mirror by generating hydrogen radicals in the apparatus and reacting the contaminants with the hydrogen radicals.

However, it has not been studied in the reflective photomask blank described in PTL 2 that the light absorption layer has resistance to hydrogen radicals (hydrogen radical resistance). Therefore, an absorption film pattern cannot be stably maintained by the introduction into an EUV exposure apparatus, and as a result, there is a possibility that the transferability deteriorates.

# EP 4 220 299 A1

Citation List

Patent Literatures

PTL 1: JP 2011-176162 A
PTL 2: JP 2007-273678 A
PTL 3: JP 2011-530823 A

Summary of Invention

Technical Problem

The present invention has been made in view of the above-described problems. It is an object of the present invention to provide a reflective photomask blank which enables the long use of a photomask by improving the dimensional accuracy and the shape accuracy of a pattern to be transferred onto a wafer by reducing the shadowing effect and improving the rectangularity of a mask pattern and by imparting hydrogen radical resistance and a reflective photomask produced using the reflective photomask blank.

Solution to Problem

To achieve the above-described object, a reflective photomask blank according to one aspect of the present invention is a reflective photomask blank for producing a reflective photomask for pattern transfer using an extreme ultraviolet as a light source, and the reflective photomask blank includes: a substrate; a reflective part formed on the substrate to reflect an incident light; and a low reflective part formed on the reflective part to absorb the incident light, in which the low reflective part is a layer containing at least one or more materials selected from a first material group and at least one or more materials selected from a second material group different from the first material group, the content of the at least one or more materials selected from the first material group decreases from the side of the substrate toward the side of the outermost surface of the low reflective part, the content of the at least one or more materials selected from the second material group increases from the side of the substrate toward the side of the outermost surface of the low reflective part, the first material group contains tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides thereof, and the second material group contains tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb), and oxides, nitrides, and oxynitrides thereof.

In the reflective photomask blank according to one aspect of the present invention, the low reflective part may be a structure body in which, even when divided into a plurality of layers, the total film thickness of the entire low reflective part is at least 33 nm or more, and the at least one or more materials selected from the first material group are contained in a proportion of 20 at% or more in total in the entire low reflective part.

In the reflective photomask blank according to one aspect of the present invention, the low reflective part may be a structure body in which, even when divided into a plurality of layers, the total film thickness of the entire low reflective part is at least 26 nm or more and the at least one or more materials selected from the first material group are contained in a proportion of 55 at% or more in total in the entire low reflective part.

In the reflective photomask blank according to one aspect of the present invention, the low reflective part may be a structure body in which, even when divided into a plurality of layers, the total film thickness of the entire low reflective part is at least 17 nm or more and the at least one or more materials selected from the first material group are contained in a proportion of 95 at% or more in total in the entire low reflective part.

In the reflective photomask blank according to one aspect of the present invention, an outermost surface layer of the low reflective part may be a structure body containing the at least one or more materials selected from the second material group in a proportion of 80 at% or more in total.

In the reflective photomask blank according to one aspect of the present invention, when a region having a depth within 50% from the surface of the low reflective part is the outermost surface layer of the low reflective part in a case where the thickness dimension of the low reflective part is 100%, the outermost surface layer of the low reflective part may be a structure body containing the at least one or more materials selected from the second material group in a proportion of 80 at% or more in total.

In the reflective photomask blank according to one aspect of the present invention, the outermost surface layer of the low reflective part may have a film thickness of 0.5 nm or more and 30 nm or less.

A reflective photomask according to one aspect of the present invention includes: a substrate; a reflective part formed on the substrate to reflect an incident light; and a low reflective part formed on the reflective part to absorb the incident light, in which the low reflective part is a layer containing at least one or more materials selected from a first material group and at least one or more materials selected from a second material group different from the first material group, the content of the at least one or more materials selected from the first material group decreases from the side of the substrate toward the side of an outermost surface of the low reflective part, the content of the at least one or more materials selected from the second material group increases from the side of the substrate toward the side of the outermost surface of the low reflective part, the first material group contains tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides thereof, and the second material group contains tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb), and oxides, nitrides, and oxynitrides thereof.

Advantageous Effects of Invention

According to one aspect of the present invention, the formation of the low reflective part where the content of compound materials having high absorptivity to the EUV light is reduced from the substrate side to the outermost surface side and the content of compound materials having high hydrogen radical resistance is increased from the substrate side toward the outermost surface side reduces the shadowing and improves the rectangularity of the mask pattern, which improves the dimensional accuracy and the shape accuracy of the pattern to be transferred onto the wafer and imparts the hydrogen radical resistance, and therefore the photomask can be used over a long period of time.

Brief Description of Drawings

FIG. 1 is a schematic cross-sectional view illustrating the structure of a reflective photomask blank according to an embodiment of the present invention;
FIG. 2 is a schematic cross-sectional view illustrating the structure of a reflective photomask according to the embodiment of the present invention;
FIG. 3 is a graph showing the optical constant of each metal material at the wavelength of an EUV light;
FIG. 4 is a conceptual view illustrating an example of the content (concentration) distribution of a first material group and the content (concentration) distribution of a second material group in an absorption layer provided in the reflective photomask blank and the reflective photomask according to the embodiment of the present invention;
FIG. 5 is a conceptual view illustrating an example of the content distribution of the first material group and the content distribution of the second material group in the absorption layer provided in the reflective photomask blank and the reflective photomask according to the embodiment of the present invention;
FIG. 6 is a conceptual view illustrating an example of the content distribution of the first material group and the content distribution of the second material group in the absorption layer provided in the reflective photomask blank and the reflective photomask according to the embodiment of the present invention;
FIG. 7 is a conceptual view illustrating an example of the content distribution of the first material group and the content distribution of the second material group in the absorption layer provided in the reflective photomask blank and the reflective photomask according to the embodiment of the present invention;
FIG. 8 is a schematic cross-sectional view illustrating the structure of a reflective photomask blank according to Examples of the present invention;
FIG. 9 is a schematic cross-sectional view illustrating a step of manufacturing the reflective photomask according to Examples of the present invention;
FIG. 10 is a schematic cross-sectional view illustrating a step of manufacturing the reflective photomask according to Examples of the present invention;
FIG. 11 is a schematic cross-sectional view illustrating a step of manufacturing the reflective photomask according to Examples of the present invention;
FIG. 12 is a schematic cross-sectional view illustrating the structure of the reflective photomask according to Examples of the present invention;
FIG. 13 is a schematic plan view illustrating a design pattern of the reflective photomask according to Examples of the present invention;
FIG. 14 is a schematic cross-sectional view illustrating the structure of a reflective photomask blank which is an existing reflective photomask blank according to Comparative Example of the present invention and which has an absorption layer of a double-layer structure; and

FIG. 15 is a schematic cross-sectional view illustrating the structure of a reflective photomask which is an existing reflective photomask according to Comparative Example of the present invention and which has an absorption layer of a double-layer structure.

Description of Embodiments

An embodiment of the present invention is described below but the present invention is not limited to the embodiment described below. In the embodiment described below, technically preferable limitations are made for implementing the present invention, but the limitations are not essential requirements of the present invention.

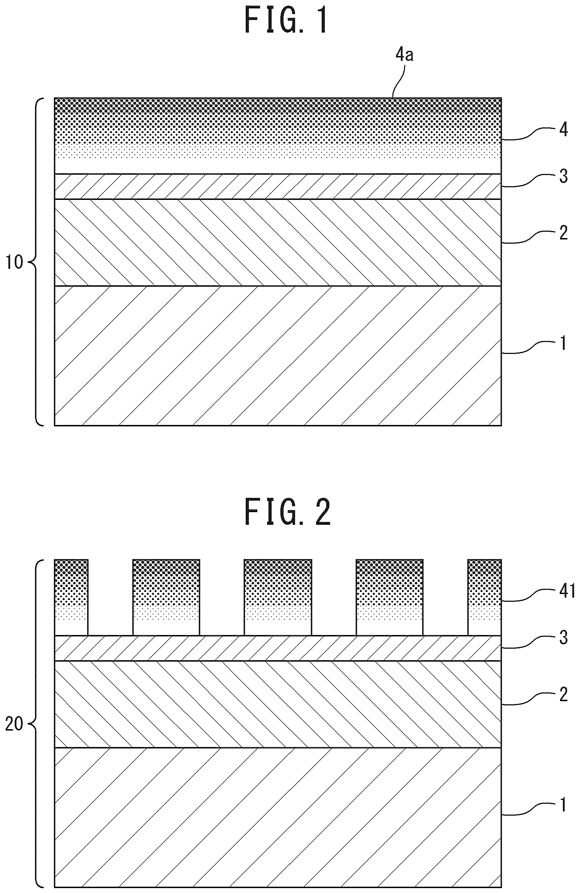

FIG. 1 is a schematic cross-sectional view illustrating the structure of a reflective photomask blank 10 according to the embodiment of the present invention. FIG. 2 is a schematic cross-sectional view illustrating the structure of a reflective photomask 20 according to the embodiment of the present invention. Herein, the reflective photomask 20 according to the embodiment of the present invention illustrated in FIG. 2 is formed by patterning an absorption layer 4 of the reflective photomask blank 10 according to the embodiment of the present invention illustrated in FIG. 1.

(Entire configuration)

As illustrated in FIG. 1, the reflective photomask blank 10 according to the embodiment of the present invention includes a substrate 1, a reflective layer 2 formed on the substrate 1, a capping layer 3 formed on the reflective layer 2, and an absorption layer 4 formed on the capping layer 3. More specifically, the reflective photomask blank 10 according to the embodiment of the present invention is a reflective photomask blank for producing a reflective photomask for pattern transfer using an extreme ultraviolet as a light source and includes the substrate 1, the reflective layer 2 and the capping layer 3 formed on the substrate 1 and functioning as reflective parts reflecting an incident light, and the absorption layer 4 formed on the reflective part and functioning as a low reflective part absorbing the incident light. The configuration and the like of the layers described above are described below.

(Substrate)

For the substrate 1 according to the embodiment of the present invention, a flat Si substrate, synthetic quartz substrate, or the like is usable. Further, a low thermal expansion glass to which titanium is added is usable for the substrate 1. However, this embodiment is not limited to the above and any material having a small thermal expansion coefficient may be acceptable.

(Reflective layer)

The reflective layer 2 according to the embodiment of the present invention is a layer constituting a part of the reflective part. The reflective layer 2 according to the embodiment of the present invention is a layer reflecting an EUV light (extreme ultraviolet light), which is an exposure light, and contains a multi-layer reflective film containing a combination of materials having greatly different refractive indices to the EUV light, for example. As the multi-layer reflective film, one formed by repeatedly depositing a layer containing a combination of Mo (molybdenum) and Si (silicon) or Mo (molybdenum) and Be (beryllium) by about 40 cycles is mentioned, for example.

(Capping layer)

The capping layer 3 according to the embodiment of the present invention is a layer constituting a part of the reflective part. The capping layer 3 according to the embodiment of the present invention is formed of a material having resistance to dry etching performed in forming a transfer pattern on the absorption layer 4 and functions as an etching stopper to prevent damage to the reflective layer 2 in etching the absorption layer 4. The capping layer 3 is formed of Ru (ruthenium), for example. Herein, the capping layer 3 may not be formed depending on materials of the reflective layer 2 and the etching conditions.

Although not illustrated in the drawings, a back surface conductive film can be formed on the surface on which the reflective layer 2 is not formed of the substrate 1. The back surface conductive film is a film for fixing the reflective photomask 20 utilizing the principle of an electrostatic chuck when the reflective photomask 20 is installed in an exposure machine.

(Absorption layer)

The absorption layer 4 of the reflective photomask blank 10 is a layer formed into an absorption pattern layer 41 (see FIG. 2) of the reflective photomask 20 by removing a part of the absorption layer 4. In the EUV lithography, the EUV light is obliquely incident with respect to the substrate horizontal plane of the reflective photomask 20 and reflected by the reflective layer 2, but the transfer performance onto a wafer sometimes deteriorates due to a shadowing effect in which the absorption pattern layer 41 interferes with an optical path. This deterioration of the transfer performance is reduced by reducing the thickness of the absorption layer 4 absorbing the EUV light. The thickness of the absorption layer 4 can be reduced by applying a material having higher absorptivity to the EUV light than that of a conventional material, i.e., a material having a high extinction coefficient k to a wavelength of 13.5 nm.

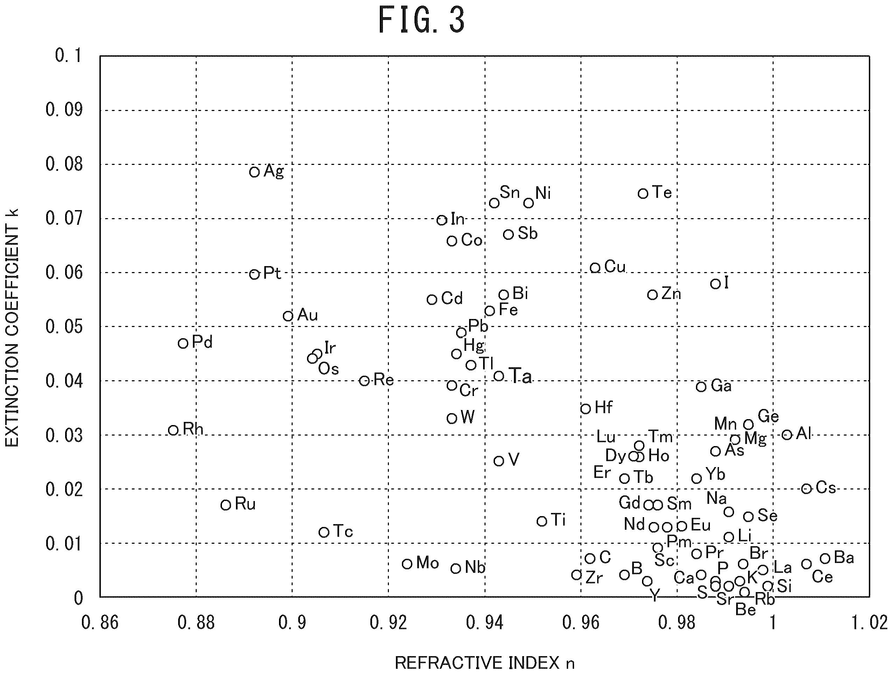

FIG. 3 is a graph showing the optical constants to the wavelength of 13.5 nm of the EUV light of each metal material. The horizontal axis of FIG. 3 represents the refractive index n and the vertical axis represents the extinction coefficient k. The extinction coefficient k of tantalum (Ta), which is a main material of the conventional absorption layer 4, is 0.041. Compound materials having a larger extinction coefficient k can reduce the thickness of the absorption layer 4 as compared with conventional compound materials. When the extinction coefficient k is 0.06 or more, the thickness of the absorption layer 4 can be sufficiently reduced, and therefore the shadowing effect can be reduced.

As materials satisfying a combination of the optical constants (nk value) described above, silver (Ag), platinum (Pt), indium (In), cobalt (Co), tin (Sn), nickel (Ni), and tellurium (Te) are mentioned, for example, as illustrated in FIG. 3.

Materials (elements) that can be added to the absorption layer 4 are described in detail below.

The absorption layer 4 is a layer containing at least one or more materials selected from a first material group described later and at least one or more materials selected from a second material group different from the first material group described later.

In the absorption layer 4, the content of the at least one or more materials selected from the first material group decreases from the side of the substrate 1 toward the side of an outermost surface 4a of the absorption layer 4 and the content of the at least one or more materials selected from the second material group increases from the side of the substrate 1 toward the side of the outermost surface 4a of the absorption layer 4.

Herein, the first material group described above contains tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides thereof. The second material group described above contains tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb), and oxides, nitrides, and oxynitrides thereof.

The absorption layer 4 is preferably a structure body in which, even when divided into a plurality of layers, the total film thickness of the entire absorption layer 4 is at least 33 nm or more and the at least one or more materials selected from the first material group are contained in a proportion of 20 at% or more in total in the entire absorption layer 4.

The absorption layer 4 is preferably a structure body in which, even when divided into a plurality of layers, the total film thickness of the entire absorption layer 4 is at least 26 nm or more and the at least one or more materials selected from the first material group are contained in a proportion of 55 at% or more in total in the entire absorption layer 4.

The absorption layer 4 is preferably a structure body in which, even when divided into a plurality of layers, the total film thickness of the entire absorption layer 4 is at least 17 nm or more and the at least one or more materials selected from the first material group are contained in a proportion of 95 at% or more in total in the entire absorption layer 4.

An outermost surface layer of the absorption layer 4 is preferably a structure body containing the at least one or more materials selected from the second material group in a proportion of 80 at% or more in total.

When a region having a depth within 50% from the surface of the absorption layer 4 is defined as the "outermost surface layer of the absorption layer 4" in a case where the thickness dimension of the absorption layer 4 is 100%, the outermost surface layer of the absorption layer 4 is preferably a structure body containing the at least one or more materials selected from the second material group in a proportion of 80 at% or more in total.

The outermost surface layer of the absorption layer 4 preferably has a film thickness of 0.5 nm or more and 30 nm or less. The film formation limit of the film thickness of the outermost surface layer of the absorption layer 4 is 0.5 nm. It is extremely difficult to form a film having a thickness of less than 0.5 nm. When the film thickness of the outermost surface layer of the absorption layer 4 exceeds 30 nm, the effect of shadowing tends to become noticeable.

The distributions of the content (concentration) of the materials contained in the first material group and the content (concentration) of the materials contained in the second material group in the absorption layer 4 are described below.

In this embodiment, the content of the materials contained in the first material group preferably decreases straightly (linearly), curvedly (e.g., S-curve), or exponentially from the substrate 1 side toward the outermost surface 4a side of the absorption layer 4.

In this embodiment, the content of the materials contained in the second material group preferably increases straightly (linearly), curvedly (e.g., S-curve), or exponentially from the substrate 1 side toward the outermost surface 4a side of the absorption layer 4.

At least one of the first material group and the second material group preferably has a uniform composition in at least one of regions on the substrate 1 side and the outermost surface 4a side of the absorption layer 4. In this embodiment, the "region on the substrate 1 side" means a lower 10% region in the entire absorption layer 4 and the "region on the outermost surface 4a side" means an upper 10% region in the entire absorption layer 4.

When the absorption layer 4 is divided into two equal parts in the thickness direction, a point (place) where the content (concentration) of the first material group and the content (concentration) of the second material group are the same may be located on the substrate 1 side or may be located on the outermost surface 4a side of the absorption layer 4.

The region (lower 10% region in the entire absorption layer 4) on the substrate 1 side may not be formed of only the materials contained in the first material group. The region (upper 10% region in the entire absorption layer 4) on the outermost surface 4a side may not be formed of only the materials contained in the second material group. More specifically, the region on the substrate 1 side may contain the materials contained in the second material group and the region on the outermost surface 4a side may contain the materials contained in the first material group.

The distributions of the content (concentration) of the materials contained in the first material group and the content (concentration) of the materials contained in the second material group in the absorption layer 4 are described below with reference to the drawings.

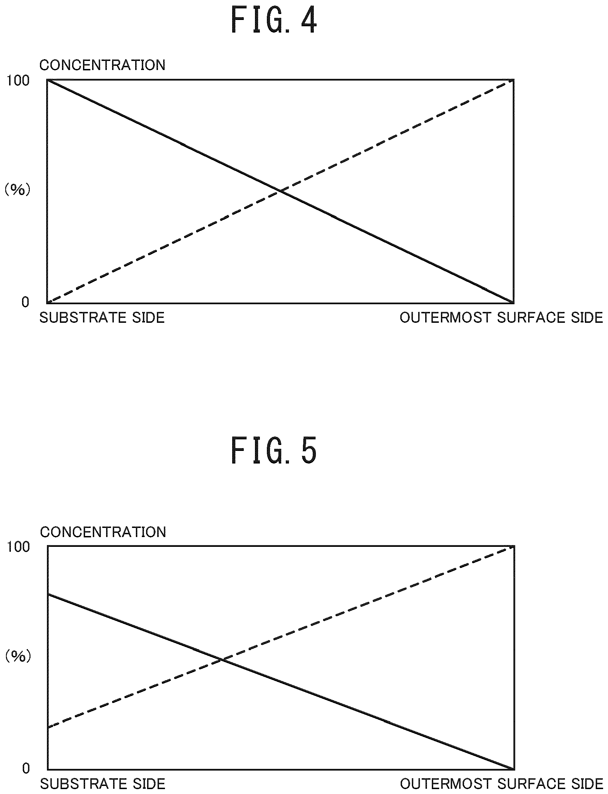

FIGS. 4 to 7 are conceptual views illustrating the content distribution (concentration distribution) of the materials contained in the first material group and the content distribution (concentration distribution) of the materials contained in the second material group. The vertical axis in each of FIGS. 4 to 7 indicates the contents (%) of the first material group and the second material group in the entire absorption layer 4 and the horizontal axis indicates the depth direction in the entire absorption layer 4.

FIG. 4 illustrates an aspect in which the content (solid line) of the materials contained in the first material group decreases straightly (linearly) from the substrate 1 side toward the outermost surface 4a side of the absorption layer 4 and the content (broken line) of the materials contained in the second material group increases straightly (linearly) from the substrate 1 side toward the outermost surface 4a side of the absorption layer 4.

FIG. 5 illustrates an aspect in which the content (solid line) of the materials contained in the first material group decreases straightly (linearly) from the substrate 1 side toward the outermost surface 4a side of the absorption layer 4 and the content (broken line) of the materials contained in the second material group increases straightly (linearly) from the substrate 1 side toward the outermost surface 4a side of the absorption layer 4, and illustrates an aspect in which the point (place) where the content (concentration) of the first material group and the content (concentration) of the second material group are the same is located on the substrate 1 side when the absorption layer 4 is divided into two equal parts in the thickness direction and the region on the substrate 1 side contains the materials contained in the second material group and the region on the outermost surface 4a side contains the materials contained in the first material group.

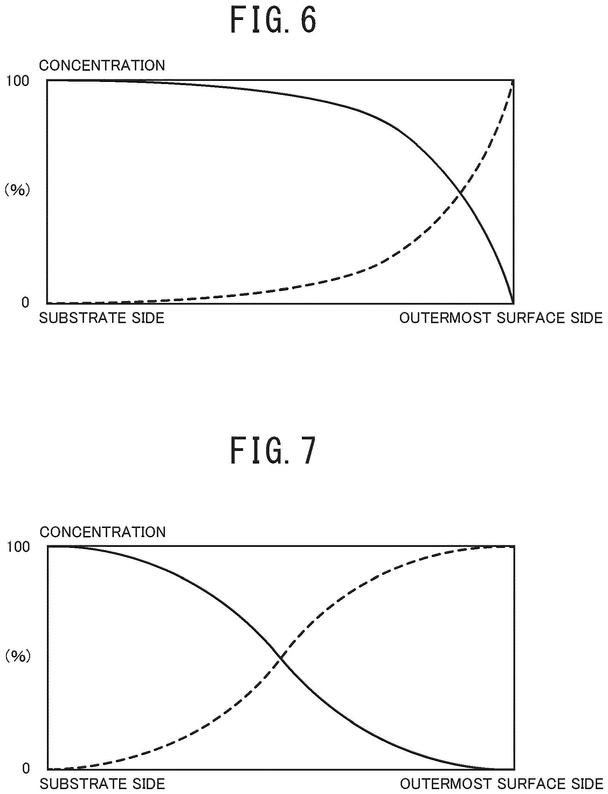

FIG. 6 illustrates an aspect in which the content (solid line) of the materials contained in the first material group decreases exponentially from the substrate 1 side toward the outermost surface 4a side of the absorption layer 4 and the content (broken line) of the materials contained in the second material group exponentially increases from the substrate 1 side toward the outermost surface 4a side of the absorption layer 4, and illustrates an aspect in which the region on the substrate 1 side and the region on the outermost surface 4a side each have a uniform composition and the point (place) where the content (concentration) of the first material group and the content (concentration) of the second material group are the same is located on the outermost surface 4a side when the absorption layer 4 is divided into two equal parts in the thickness direction.

FIG. 7 illustrates an aspect in which the content (solid line) of the materials contained in the first material group decreases curvedly (as if drawing an inverted S-curve) from the substrate 1 side toward the outermost surface 4a side of the absorption layer 4 and the content (broken line) of the materials contained in the second material group increases curvedly (as if drawing an S-curve) from the substrate 1 side toward the outermost surface 4a side of the absorption layer 4, and illustrates an aspect in which the region on the substrate 1 side and the region on the outermost surface 4a side each have a uniform composition.

In the aspects described above, since the absorption layer 4 is provided in which the content of compound materials (materials contained in the first material group) having high absorptivity to the EUV light decreases from the substrate 1 side to the outermost surface 4a side and the content of compound materials (materials contained in the second material group) having high hydrogen radical resistance increases from the substrate 1 side toward the outermost surface 4a side, the shadowing decreases and the rectangularity of the mask pattern is improved, and therefore the dimensional accuracy and the shape accuracy of the pattern to be transferred onto the wafer are improved and the hydrogen radical resistance is imparted, and therefore a photomask capable of being used over a long period of time can be provided.

The distributions of the contents of the first material group and the second material group in this embodiment are not limited to the distributions described above, and combinations of the distributions described above may be acceptable.

In general, the reflective photomask blank needs to be processable for patterning. Among the materials above, tin oxide is known to be dry-etchable by a chlorine-based gas. Therefore, the absorption layer 4 more preferably contains materials containing tin (Sn) and oxygen (O).

The reflective photomask is exposed to a hydrogen radical environment, and therefore the reflective photomask cannot withstand long-term use unless the absorption layer 4 contains an absorption material having high hydrogen radical resistance (second material group). In this embodiment, a material having a film reduction rate of 0.1 nm/s or less under a hydrogen radical environment having a power of 1 kW and a hydrogen pressure of 0.36 mbar or less using a microwave plasma is used as a material having high hydrogen radical resistance.

Among the materials above, a tin (Sn) simple substance is known to have low resistance to hydrogen radicals, but the addition of oxygen (O) increases the hydrogen radical resistance. As shown in Table 1, the hydrogen radical resistance was confirmed in materials in which the atomic number ratio of tin (Sn) and oxygen (O) exceeded 1:2. This is considered to be because, when the atomic number ratio of tin (Sn) and oxygen (O) is 1:2 or less, all of the tin (Sn) bonds do not form tin oxide ($SnO_2$), and the atomic number ratio exceeding 1:2 is required for making a film entirely formed of tin oxide ($SnO_2$).

Table 1 shows the hydrogen radical resistance associated with the element number ratio of Sn and O according to the embodiment of the present invention. The atomic number ratios shown in Table 1 are the results of measuring materials formed to have a film thickness of 1 um by EDX (energy dispersive X-ray spectroscopy). Herein, a case where the atomic number ratio of tin (Sn) and oxygen (O) is 1:2 is indicated as "Δ" in Table 1 because a variation was confirmed in repeated evaluations. In this embodiment, "Δ" and "o" are acceptable because there are no problems in using the materials.

[Table 1]

| O/Sn ratio | 1.5 | 2 | 2.5 | 3 | 3.5 |
|---|---|---|---|---|---|
| Hydrogen radical resistance | × | Δ* | ○ | ○ | ○ |
| *A variation was confirmed in repeated evaluations. | | | | | |

The materials containing tin (Sn) and oxygen (O) that can be used to form the absorption layer 4 preferably contain oxygen in a larger amount than the amount of stoichiometric tin oxide. More specifically, the atomic number ratio of tin (Sn) and oxygen (O) in the materials of the absorption layer 4 preferably exceeds 1:2.

When the atomic number ratio of tin (Sn) and oxygen (O) exceeds 1:3.5, the absorptivity to the EUV light decreases, and therefore the atomic number ratio of tin (Sn) and oxygen (O) is preferably 1:3.5 or less and more preferably 1:3 or less. More specifically, when the absorption layer 4 is formed of the materials containing tin (Sn) and oxygen (O), the oxygen (O) content is preferably within the range of twice or more and 3.5 times or less the tin (Sn) content in the atomic number ratio.

The absorption layer 4 preferably contains tin (Sn) and oxygen (O) in a proportion of 50 at% or more in total with respect to the entire absorption layer 4.

This is because, when the absorption layer 4 contains ingredients other than tin (Sn) and oxygen (O), there is a possibility that both the EUV light absorptivity and the hydrogen radical resistance decrease, but, when the ingredients are contained in a proportion of less than 50 at%, both the EUV light absorptivity and the hydrogen radical resistance decrease very slightly, and the performance as the absorption layer 4 of the EUV mask (reflective photomask) hardly decreases.

In this embodiment, the absorption layer 4 may contain the materials contained in the first material group and the materials contained in the second material group in a proportion of 50 at% or more in total with respect to the entire absorption layer 4.

As materials other than tin (Sn) and oxygen (O), Ta, Pt, Te, Zr, Hf, Ti, W, Si, Cr, In, Pd, Ni, Al, Ni, F, N, C, and H may be mixed in the absorption layer 4.

The mixing of In within the range of 10 at% or more and less than 50 at%, for example, makes it possible to impart conductivity to the film (absorption layer 4) while the high absorptivity to the EUV light is ensured. This makes it possible to enhance the inspection performance in mask pattern inspection using the EUV light having a wavelength of 190 nm to 260 nm. Alternatively, the mixing of N or Hf within the range of 10 at% or more and less than 50 at%, for example, makes it possible to make the film quality of the absorption layer 4 more amorphous. Therefore, the roughness, the in-plane dimensional uniformity, and the in-plane uniformity of a transferred image of the absorption pattern layer 41 after dry etching are improved.

As described above, the compound materials containing Ta as the main ingredient have been applied to an absorption layer of a conventional EUV reflective photomask. In this case, it has been necessary to set the film thickness to 40 nm or more to obtain an optical density OD (Equation 1) of 1 or more and set the film thickness to 70 nm or more to obtain the OD of 2 or more, the OD being an index indicating the light intensity contrast between the absorption layer and the reflective layer. The extinction coefficient k of Ta is 0.041, but, by applying compound materials containing tin (Sn) and oxygen (O) having the extinction coefficient k of 0.06 or more to the absorption layer, the film thickness can be set to 17 nm or less even when the OD of 1 or more is obtained and the film thickness can be set to 45 nm or less even when the OD of 2 or more is obtained according to the Beer's Law. When the film thickness is 45 nm or more, the shadowing effect becomes substantially the same as that of the conventional compound materials containing Ta as the main ingredient and having a film thickness of 60 nm.

$$OD = -\log(Ra/Rm) \cdots \text{(Expression 1)}$$

Therefore, the film thickness of the absorption layer 4 is preferably 17 nm or more and 45 nm or less.

The absorption layer of the conventional EUV reflective photomask contains an oxide film containing Ta as the main ingredient for the upper layer, which is the outermost surface, and a nitride film containing Ta as the main ingredient for the lower layer in many cases, and the absorption layer has a boundary (interface) between the upper layer and the lower layer in many cases. Therefore, when the absorption layer of the conventional EUV reflective photomask is patterned by dry etching, and then the cross-sectional shape is observed, a step is sometimes generated in the boundary (interface) between the upper layer and the lower layer. Such a step in the absorption layer causes a deterioration of the dimensional accuracy and the shape accuracy of a pattern to be transferred onto a wafer, and therefore the absorption layer after patterning desirably has no steps.

[Example 1]

Examples of the reflective photomask blank and the reflective photomask according to the present invention are described below.

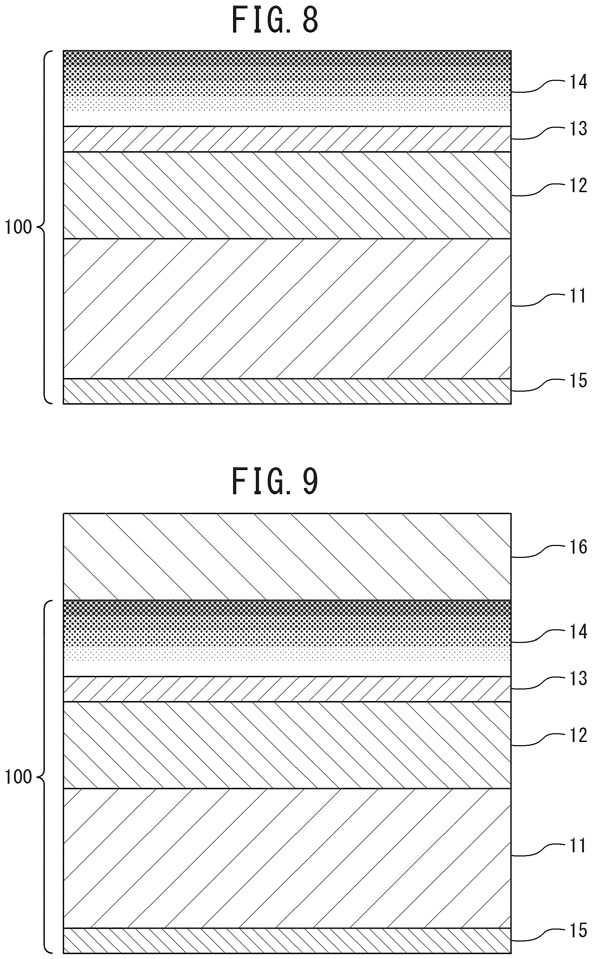

As illustrated in FIG. 8, a reflective layer 12 is formed which is formed by depositing 40 pairs each containing silicon (Si) and molybdenum (Mo) on a synthetic quartz substrate 11 having low thermal expansion characteristics. The film thickness of the reflective layer 12 was 280 nm.

Next, a capping layer 13 formed of ruthenium (Ru) was formed as an intermediate film to have a film thickness of 3.5 nm on the reflective layer 12.

Next, on the capping layer 13, an absorption layer 14 having a region (layer) containing tin (Sn) and oxygen (O) and a region (layer) containing tantalum (Ta) and oxygen (O) was formed such that the film thicknesses of the regions were 26 nm and 7 nm, respectively. Herein, sputtering was continuously performed not to generate the boundary (interface) in the film formation of SnO and TaO of the absorption layer 14. This point is described in detail below.

In this example, a film (layer) containing tin (Sn) and oxygen (O) was formed to have a film thickness of 26 nm as the absorption layer 14 on the capping layer 13. Then, when the thickness of the film (layer) containing tin (Sn) and oxygen (O) reached 26 nm, the formation of a film (layer) containing tin (Sn) and oxygen (O) and the formation of a film (layer) containing tantalum (Ta) and oxygen (O) were simultaneously performed. Thus, a film (layer) containing SnO and TaO was formed to have a film thickness of about 0.5 nm. Thereafter, the formation of the film (layer) containing tin (Sn) and oxygen (O) was completed, and then the film (layer) containing tantalum (Ta) and oxygen (O) was formed to have a thickness of 7 nm. Thus, the absorption layer 14 was formed not to generate the boundary (interface) between the region containing tin (Sn) and oxygen (O) and the region containing tantalum (Ta) and oxygen (O).

The atomic number ratio of tin (Sn) and oxygen (O) thus formed in the absorption layer 14 was 1:2.5 as measured by the EDX (energy dispersive X-ray analysis). The atomic number ratio of tantalum (Ta) and oxygen (O) was 1:1.9 as measured by the EDX (energy dispersive X-ray analysis).

When measured by XRD (X-ray diffractometer), the film quality of the absorption layer 14 was found to be slightly crystalline, but amorphous.

Next, a back surface conductive film 15 formed of chromium nitride (CrN) was formed with a thickness of 100 nm on the side on which the reflective layer 12 was not formed of the substrate 11, thereby producing a reflective photomask blank 100 of Example 1.

In Example 1, for the formation of each film on the substrate 11, a multi-source sputtering apparatus was used. The film thickness of each film was controlled by a sputtering time. The absorption layer 14 was formed such that the O/Sn ratio was 2.5 and the O/Ta ratio was 1.9 by controlling the amount of oxygen introduced into a chamber during sputtering by a reactive sputtering method.

Next, a method for producing a reflective photomask 200 of Example 1 is described using FIGS. 9 to 12.

A positive chemically amplified resist (SEBP9012: manufactured by Shin-Etsu Chemical Co., Ltd.) was applied onto the absorption layer 14 of the reflective photomask blank 100 to have a film thickness of 120 nm by spin coating and baked at 110°C for 10 minutes to form a resist film 16 as illustrated in FIG. 9.

Next, a predetermined pattern was drawn on the resist film 16 by an electron beam drawing machine (JBX3030: manufactured by JEOL Ltd.).

Thereafter, pre-baking treatment was performed at 110°C for 10 minutes, and then development treatment was performed using a spray-development machine (SFG3000: manufactured by SIGMAMELTEC LTD.).

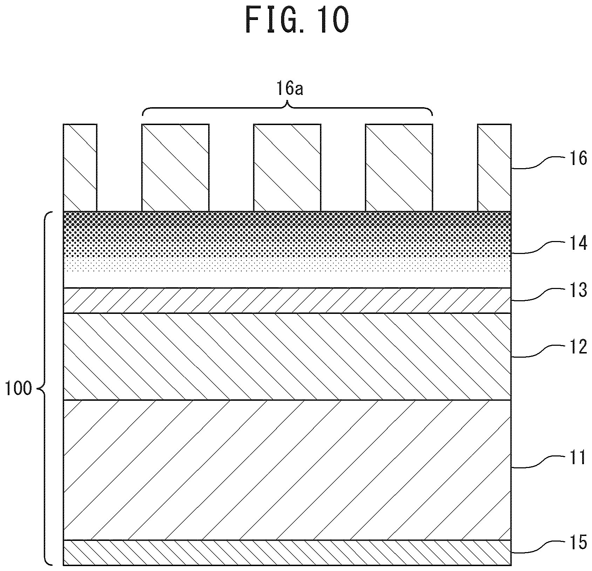

Thus, a resist pattern 16a was formed as illustrated in FIG. 10.

Next, the absorption layer 14 was patterned by dry etching mainly containing a chlorine-based gas using the resist pattern 16a as an etching mask.

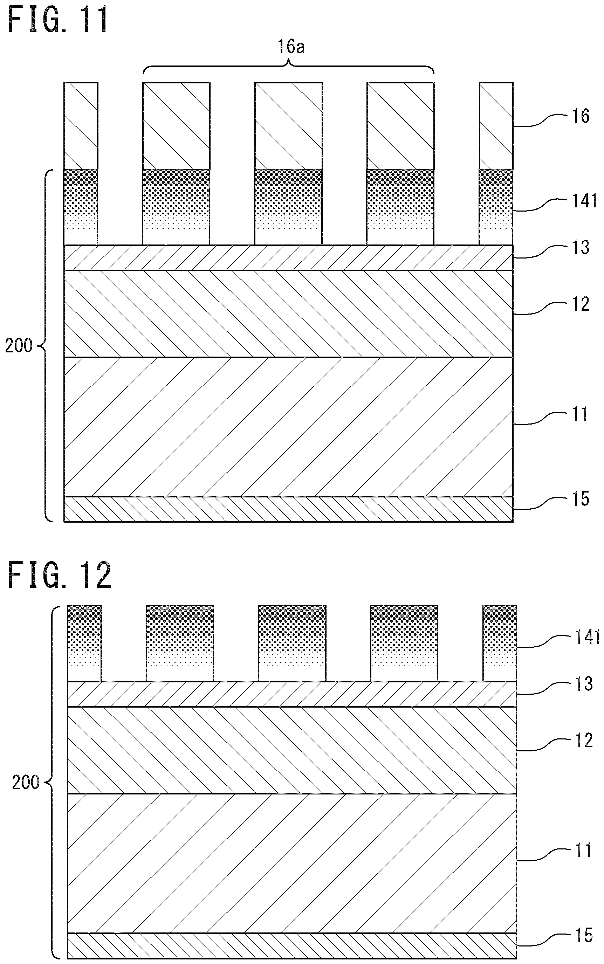

Thus, an absorption pattern layer 141 was formed on the capping layer 13 as illustrated in FIG. 11.

Next, the resist pattern 16a was peeled off, thereby producing the reflective photomask 200 of this example illustrated in FIG. 12.

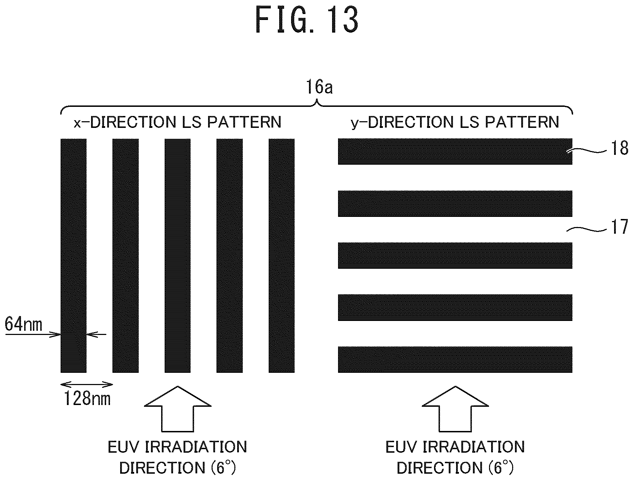

In this example, the transfer pattern (shape of the absorption pattern layer 141) formed on the absorption layer 14 contains an LS (line and space) pattern with a line width of 64nm, an LS pattern with a line width of 200 nm for measuring the film thickness of an absorption layer using AFM, and 4 mm square absorption layer removed parts for EUV reflectance measurement on the reflective photomask 200 for transfer evaluation. The LS pattern with a line width of 64 nm was designed in each of the x-direction and the y-direction as illustrated in FIG. 13 such that the effect of the shadowing effect by EUV irradiation was able to be easily viewed.

[Comparative Example 1]

As Comparative Example 1, a conventional EUV reflective photomask blank was produced as follows.

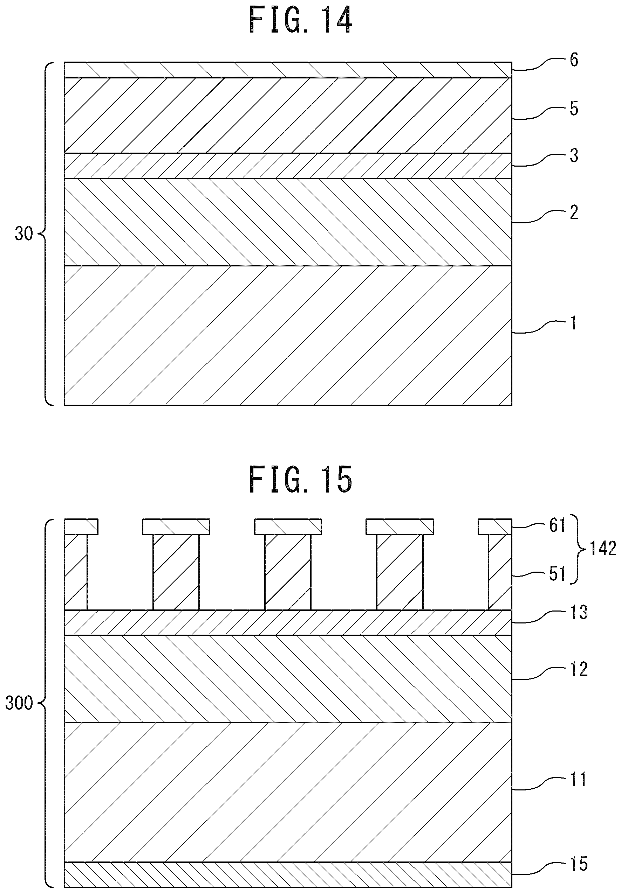

As illustrated in FIG. 14, a lower layer 5 constituting the absorption layer was formed by such film formation that the atomic number ratio of tantalum (Ta) and nitrogen (N) was 1:0.25 and the film thickness was 58 nm, and then an upper layer 6 constituting the absorption layer was formed by such film formation that the atomic number ratio of tantalum (Ta) and oxygen (O) was 1:1.9 and the film thickness was 2 nm. Thus, a reflective photomask blank 30 of Comparative Example 1 was produced. The boundary (interface) was formed between the lower layer 5 and the upper layer 6 thus formed.

Next, a reflective photomask 300 of Comparative Example 1 was produced in the same manner as in Example 1 as illustrated in FIG. 15. As illustrated in FIG. 15, the reflective photomask 300 of Comparative Example 1 includes an absorption pattern layer (lower layer) 51 and an absorption pattern layer (upper layer) 61 as an absorption pattern layer 142. However, the absorption pattern layer 142 is a film in which TaN and TaO are separated in the upper layer and the lower layer, and thus is not a film having a continuously changed composition.

[Example 2]

The absorption layer 14 was formed such that the atomic number ratio of tin (Sn) and oxygen (O) was 1:2.5. In a state where the total content of tin (Sn) and oxygen (O) was set to 55 at% of the entire absorption layer 14 and Ta was contained in the proportion of the remaining 45 at%, film formation was performed such that the film thickness of the absorption layer 14 was 26 nm. The reflective photomask blank 100 and the reflective photomask 200 of Example 2 were produced in the same manner as in Example 1 except for the above.

[Example 3]

The absorption layer 14 was formed such that the atomic number ratio of tin (Sn) and oxygen (O) was 1:2.5. In a state where the total content of tin (Sn) and oxygen (O) was set to 95 at% of the entire absorption layer 14 and Ta was contained in the proportion of the remaining 5 at%, film formation was performed such that the film thickness of the absorption layer 14 was 26 nm. The reflective photomask blank 100 and the reflective photomask 200 of Example 3 were produced in the same manner as in Example 1 except for the above.

[Example 4]

The absorption layer 14 was formed such that the atomic number ratio of tin (Sn) and oxygen (O) was 1:2.5. In a state where the total content of tin (Sn) and oxygen (O) was set to 95 at% of the entire absorption layer 14 and Ta was contained in the proportion of the remaining 5 at%, film formation was performed such that the film thickness of the absorption layer 14 was 17 nm. The reflective photomask blank 100 and the reflective photomask 200 of Example 4 were produced in the same manner as in Example 1 except for the above.

[Example 5]

The absorption layer 14 was formed such that the atomic number ratio of tin (Sn) and oxygen (O) was 1:2.5. In a state where the total content of tin (Sn) and oxygen (O) was set to 60 at% of the entire absorption layer 14 and Si was contained in the proportion of the remaining 40 at%, film formation was performed such that the film thickness of the absorption layer 14 was 33 nm. The reflective photomask blank 100 and the reflective photomask 200 of Example 5 were produced in the same manner as in Example 1 except for the above.

[Example 6]

The absorption layer 14 was formed such that the atomic number ratio of tin (Sn) and oxygen (O) was 1:2.5. In a state where the total content of tin (Sn) and oxygen (O) was set to 78 at% of the entire absorption layer 14 and Si was contained in the proportion of the remaining 22 at%, film formation was performed such that the film thickness of the absorption layer 14 was 26 nm. The reflective photomask blank 100 and the reflective photomask 200 of Example 6 were produced in the same manner as in Example 1 except for the above.

[Example 7]

The absorption layer 14 was formed such that the atomic number ratio of tin (Sn) and oxygen (O) was 1:2.5. In a state where the total content of tin (Sn) and oxygen (O) was set to 95 at% of the entire absorption layer 14 and Si was contained in the proportion of the remaining 5 at%, film formation was performed such that the film thickness of the absorption layer 14 was 17 nm. The reflective photomask blank 100 and the reflective photomask 200 of Example 7 were produced in the same manner as in Example 1 except for the above.

(Film thickness measurement)

In Examples and Comparative Example described above, the film thickness of the absorption layer 14 was measured by transmission electron microscopy.

(Reflectance measurement)

In Examples and Comparative Example described above, the reflectance Ra in a region of the absorption pattern layer 141 of the produced reflective photomask was measured by a reflectance measuring device using the EUV light.
Further, in Examples and Comparative Example described above, the reflectance Rm in a region other than the region of the absorption pattern layer 141 of the produced reflective photomask was measured by a reflectance measuring device using the EUV light.

(Hydrogen radical resistance measurement)

The reflective photomask produced by each of Examples and Comparative Example was installed in a hydrogen radical environment in which the power was 1 kW and the hydrogen pressure was 0.36 mbar or less using microwave plasma. A change in the film thickness of the absorption layer 14 after hydrogen radical treatment was confirmed using an atomic force microscope (AFM). The measurement was performed with the LS pattern with a line width of 200 nm.

(Wafer exposure evaluation)

Using an EUV exposure apparatus (NXE3300B: manufactured by ASML), the transfer pattern of the reflective photomask produced in each of Examples and Comparative Example was transferred and exposed onto a semiconductor wafer coated with an EUV positive chemically amplified resist. At this time, the exposure amount was adjusted such that the x-direction LS pattern illustrated in FIG. 13 was transferred as designed. A transferred resist pattern was observed and measured for the line width by an electron beam dimensional measuring machine, thereby confirming the resolution.
Table 2 shows these evaluation results.

[Table 2]

| | | Comp. Ex. 1 | Ex. 1 | Ex. 2 | Ex. 3 | Ex. 4 | Ex. 5 | Ex. 6 | Ex. 7 |
|---|---|---|---|---|---|---|---|---|---|
| Reflectance contrast OD | Total film thickness of absorption film | 60 nm | 33 nm | 26 nm | 26 nm | 17 nm | 33 nm | 26 nm | 17 nm |
| | Reflectance | 0.019 | 0.019 | 0.019 | 0.007 | 0.059 | 0.019 | 0.019 | 0.061 |
| | OD | 1.54 | 1.54 | 1.54 | 1.97 | 1.05 | 1.54 | 1.54 | 1.03 |
| | Determination | ◎ | ◎ | ◎ | ◎ | ○ | ◎ | ◎ | ○ |
| Hydrogen radical resistance | Film reduction rate (nm/sec) | < 0.1 | < 0.1 | < 0.1 | < 0.1 | < 0.1 | < 0.1 | < 0.1 | < 0.1 |
| | Determination | ◎ | ◎ | ◎ | ◎ | ◎ | ◎ | ◎ | ◎ |
| Cross-sectional shape of absorption film | Determination | × | ◎ | ◎ | ◎ | ◎ | ◎ | ◎ | ◎ |

The reflectance of a conventional tantalum (Ta)-based absorption layer having a film thickness of 60 nm was 0.019 (OD = 1.54), whereas, Example 3 having an SnO mixing ratio as high as 95% had good reflectance of 0.007 (OD = 1.97). On the other hand, Example 4 in which the SnO mixing ratio was as high as 95% but the film thickness of the absorption layer 14 was extremely reduced and 17 nm had the reflectance of 0.059 (OD = 1.05), and, in Example 7, the reflectance decreased to 0.061 (OD = 1.03).

Those having the OD of 1.5 or more are indicated as "◎". Those having the OD of 1.0 or more and less than 1.5 are indicated as "o". Those having the OD indicated as "◎" and "o" have no problems in using the same, and therefore were accepted in this example.

Subsequently, the hydrogen radical resistance in each of Examples and Comparative Example is shown. Herein, materials having a film reduction rate of 0.1 nm/s or less are indicated as "◎" and materials having a film reduction rate of more than 0.1 nm/s are indicated as "×". It was found that all of Comparative Example 1 which is an existing EUV reflective photomasks and Examples 1 to 7 had a film reduction rate of 0.1 nm/s or less and had sufficient resistance.

Subsequently, the determination result of the cross-sectional shape after patterning of each of the absorption layers is shown. Herein, the cross section of the absorption layer patterned by SEM was visually observed, and a case where the cross section had a step is indicated as "×" and a case where the cross section had no steps is indicated as "◎".

As described above, the reflective photomask blank and the reflective photomask in each of Examples had a sufficient OD value, sufficient hydrogen radical resistance, and no steps in the cross-sectional shape of the patterned absorption layer. Therefore, the reflective photomask blank and the reflective photomask in each of Examples improved the dimensional accuracy and the shape accuracy of the pattern to be transferred onto the wafer and imparted hydrogen radical resistance, and therefore the photomask was able to be used over a long time.

Industrial Applicability

The reflective photomask blank and the reflective photomask according to the present invention can be suitably used for forming fine patterns by EUV exposure in steps of manufacturing semiconductor integrated circuits and the like.

Reference Signs List

1       substrate
2       reflective layer
3       capping layer
4       absorption layer
4a      outermost surface
5       absorption layer (lower layer)
6       absorption layer (upper layer)
41      absorption pattern layer

| | |
|---|---|
| 51 | absorption pattern layer (lower layer) |
| 61 | absorption pattern layer (upper layer) |
| 10 | reflective photomask blank |
| 20 | reflective photomask |
| 30 | reflective photomask blank |
| 11 | substrate |
| 12 | reflective layer |
| 13 | capping layer |
| 14 | absorption layer |
| 141 | absorption pattern layer |
| 142 | absorption pattern layer (double-layer film) |
| 15 | back surface conductive film |
| 16 | resist film |
| 16a | resist pattern |
| 17 | reflective part |
| 18 | low reflective part |
| 100 | reflective photomask blank |
| 200 | reflective photomask |
| 300 | reflective photomask |

**Claims**

1. A reflective photomask blank for producing a reflective photomask for pattern transfer using an extreme ultraviolet as a light source,
   the reflective photomask blank comprising:

   a substrate;
   a reflective part formed on the substrate to reflect an incident light; and
   a low reflective part formed on the reflective part to absorb the incident light, wherein
   the low reflective part is a layer containing at least one or more materials selected from a first material group and at least one or more materials selected from a second material group different from the first material group,
   a content of the at least one or more materials selected from the first material group decreases from a side of the substrate toward a side of an outermost surface of the low reflective part,
   a content of the at least one or more materials selected from the second material group increases from the side of the substrate toward the side of the outermost surface of the low reflective part,
   the first material group contains tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides of tellurium (Te), cobalt (Co), nickel (Ni), platinum (Pt), silver (Ag), tin (Sn), indium (In), copper (Cu), zinc (Zn), and bismuth (Bi), and
   the second material group contains tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb), and oxides, nitrides, and oxynitrides of tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb).

2. The reflective photomask blank according to claim 1, wherein
   the low reflective part is a structure body in which, even when divided into a plurality of layers, a total film thickness of the entire low reflective part is at least 33 nm or more, and the at least one or more materials selected from the first material group are contained in a proportion of 20 at% or more in total in the entire low reflective part.

3. The reflective photomask blank according to claim 1, wherein
   the low reflective part is a structure body in which, even when divided into a plurality of layers, a total film thickness of the entire low reflective part is at least 26 nm or more, and the at least one or more materials selected from the first material group are contained in a proportion of 55 at% or more in total in the entire low reflective part.

4. The reflective photomask blank according to claim 1, wherein
   the low reflective part is a structure body in which, even when divided into a plurality of layers, a total film thickness of the entire low reflective part is at least 17 nm or more, and the at least one or more materials selected from the first material group are contained in a proportion of 95 at% or more in total in the entire low reflective part.

5. The reflective photomask blank according to any one of claims 2 to 4, wherein
an outermost surface layer of the low reflective part is a structure body containing the at least one or more materials selected from the second material group in a proportion of 80 at% or more in total.

6. The reflective photomask blank according to any one of claims 1 to 5, wherein

when a region having a depth within 50% from a surface of the low reflective part is the outermost surface layer of the low reflective part in a case where a thickness dimension of the low reflective part is 100%, the outermost surface layer of the low reflective part is a structure body containing the at least one or more materials selected from the second material group in a proportion of 80 at% or more in total.

7. The reflective photomask blank according to any one of claims 2 to 6, wherein the outermost surface layer of the low reflective part has a film thickness of 0.5 nm or more and 30 nm or less.

8. A reflective photomask comprising:

a substrate;
a reflective part formed on the substrate to reflect an incident light; and
a low reflective part formed on the reflective part to absorb the incident light, wherein
the low reflective part is a layer containing at least one or more materials selected from a first material group and at least one or more materials selected from a second material group different from the first material group,
a content of the at least one or more materials selected from the first material group decreases from a side of the substrate toward a side of an outermost surface of the low reflective part, and
a content of the at least one or more materials selected from the second material group increases from the side of the substrate toward the side of the outermost surface of the low reflective part,
the first material group contains tellurium (Te), cobalt (Co), nickel (Ni), platinum (Pt), silver (Ag), tin (Sn), indium (In), copper (Cu), zinc (Zn), and bismuth (Bi), and oxides, nitrides, and oxynitrides of tellurium (Te), cobalt (Co), nickel (Ni), platinum (Pt), silver (Ag), tin (Sn), indium (In), copper (Cu), zinc (Zn), and bismuth (Bi), and
the second material group contains tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb), and oxides, nitrides, and oxynitrides of tantalum (Ta), chromium (Cr), aluminum (Al), silicon (Si), ruthenium (Ru), molybdenum (Mo), zirconium (Zr), titanium (Ti), zinc (Zn), indium (In), vanadium (V), hafnium (Hf), and niobium (Nb).

# FIG. 1

4a

10

4

3

2

1

# FIG. 2

41

3

2

20

1

# FIG. 3

EP 4 220 299 A1

# FIG. 4

CONCENTRATION

(%)

100 — 0

SUBSTRATE SIDE — OUTERMOST SURFACE SIDE

# FIG. 5

CONCENTRATION

(%)

100 — 0

SUBSTRATE SIDE — OUTERMOST SURFACE SIDE

# FIG. 6

CONCENTRATION

100

(%)

0

SUBSTRATE SIDE                    OUTERMOST SURFACE SIDE

# FIG. 7

CONCENTRATION

100

(%)

0

SUBSTRATE SIDE                    OUTERMOST SURFACE SIDE

# FIG. 8

100

14
13
12
11
15

# FIG. 9

16

100

14
13
12
11
15

# FIG. 10

# FIG. 11

16a

200

16

141

13

12

11

15

# FIG. 12

200

141

13

12

11

15

# FIG. 13

16a

x-DIRECTION LS PATTERN | y-DIRECTION LS PATTERN

— 18

— 17

64nm

128nm

EUV IRRADIATION
DIRECTION (6°)

EUV IRRADIATION
DIRECTION (6°)

# FIG. 14

# FIG. 15

## INTERNATIONAL SEARCH REPORT

| International application No. |
|---|
| **PCT/JP2021/035429** |

| A. | CLASSIFICATION OF SUBJECT MATTER |
|---|---|

*G03F 1/24*(2012.01)i; *G03F 1/54*(2012.01)i; *C23C 14/08*(2006.01)i
FI:   G03F1/24; C23C14/08 N; G03F1/54

According to International Patent Classification (IPC) or to both national classification and IPC

| B. | FIELDS SEARCHED |
|---|---|

Minimum documentation searched (classification system followed by classification symbols)

G03F1/24; G03F1/54; C23C14/08

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

SPIE Digital Library

| C. | DOCUMENTS CONSIDERED TO BE RELEVANT |
|---|---|

| Category* | Citation of document, with indication, where appropriate, of the relevant passages | Relevant to claim No. |
|---|---|---|
| A | US 2019/0146331 A1 (TAIWAN SEMICONDUCTOR MANUFACTURING CO., LTD.) 16 May 2019 (2019-05-16)<br>paragraphs [0034], [0041]-[0042], fig. 1K | 1-8 |
| A | JP 2007-273678 A (HOYA CORP) 18 October 2007 (2007-10-18)<br>paragraphs [0017], [0029], fig. 1 | 1-8 |
| A | WO 2018/135468 A1 (HOYA CORP) 26 July 2018 (2018-07-26)<br>paragraph [0052] | 1-8 |

☐ Further documents are listed in the continuation of Box C.       ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **02 November 2021** | **16 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

International application No.

**PCT/JP2021/035429**

| Patent document cited in search report | | | Publication date (day/month/year) | Patent family member(s) | | | Publication date (day/month/year) |
|---|---|---|---|---|---|---|---|
| US | 2019/0146331 | A1 | 16 May 2019 | CN | 109782524 | A | |
| | | | | TW | 201923441 | A | |
| JP | 2007-273678 | A | 18 October 2007 | (Family: none) | | | |
| WO | 2018/135468 | A1 | 26 July 2018 | US | 2019/0369783 | A1 | |
| | | | | paragraph [0083] | | | |
| | | | | US | 2019/0361338 | A1 | |
| | | | | US | 2019/0384157 | A1 | |
| | | | | KR | 10-2019-0026926 | A | |
| | | | | KR | 10-2019-0100251 | A | |
| | | | | KR | 10-2019-0102192 | A | |
| | | | | KR | 10-2019-0117745 | A | |
| | | | | WO | 2018/135467 | A1 | |
| | | | | WO | 2018/159785 | A1 | |
| | | | | TW | 201831987 | A | |
| | | | | TW | 201842208 | A | |
| | | | | TW | 201842395 | A | |
| | | | | SG | 11201906153S | A | |
| | | | | SG | 11201906154P | A | |
| | | | | SG | 11201907622Y | A | |

Form PCT/ISA/210 (patent family annex) (January 2015)

25

**REFERENCES CITED IN THE DESCRIPTION**

**Patent documents cited in the description**

- JP 2011176162 A
- JP 2007273678 A
- JP 2011530823 A